# EUROPÄISCHE PATENTSCHRIFT

(11) **EP 3 182 142 B1**
(45) Veröffentlichungstag und Bekanntmachung des Hinweises auf die Patenterteilung: **09.09.2020**
(21) Anmeldenummer: 16204450.7
(22) Anmeldetag: 15.12.2016
(51) Int. Cl.: G01R 15/16

(54) **VORRICHTUNG ZUM ERKENNEN EINES SPANNUNGSSYSTEMS**
DEVICE FOR DETECTING A VOLTAGE SYSTEM
DISPOSITIF DESTINÉ À RECONNAÎTRE UN SYSTÈME DE TENSION

(30) Priorität: 15.12.2015 DE 102015121876
(43) Veröffentlichungstag der Anmeldung: 21.06.2017
(73) Patentinhaber: Bombardier Transportation GmbH, 10785 Berlin (DE)
(72) Erfinder: Maaß, Jörg-Torsten, 16515 Oranienburg (DE); Hillarius, Andreas, 13507 Berlin (DE)
(74) Vertreter: Zimmermann & Partner Patentanwälte mbB

(56) Entgegenhaltungen:
- EP-A1- 2 857 848
- EP-A2- 2 567 855
- GB-A- 641 421

## Beschreibung

Die Erfindung betrifft eine Vorrichtung zum Erkennen eines Spannungssystems, ein Schienenfahrzeug und ein Verfahren zum Erkennen eines Spannungssystems.

In verschiedenen Regionen der Erde werden unterschiedliche elektrische Spannungssysteme zum Betrieb von Schienenfahrzeugen verwendet. Im europäischen Raum werden hauptsächlich fünf verschiedene Spannungssysteme angeboten: 750 V Gleichspannung, 1,5 kV Gleichspannung, 3 kV Gleichspannung, 15 kV Wechselspannung mit einer Frequenz von 16,7 Hz und 25 kV Wechselspannung mit einer Frequenz von 50 Hz. Mehrsystemfahrzeuge mit verschiedenen Stromabnehmern für verschiedene Spannungssysteme müssen gewährleisten, dass immer derjenige Stromabnehmer für den Betrieb angehoben wird, der zu dem örtlich vorhandenen Spanungssystem passt. Daher muss das Spannungssystem sicher erkannt werden. Nachteilig ist hier, dass der Stromabnehmer für eine Erkennung des Spannungssystems bereits am Fahrdraht anliegen muss. Eine TSI-Sicherheitsrichtlinie sieht vor, dass jeder Stromabnehmer für den Fehlerfall, d.h. ein Anliegen der höchstmöglichen Betriebsspannung isoliert sein muss. Dies führt zu einem hohen Gewicht von Isolatoren, die die Stromabnehmer und mit diesen direkt verbundene Komponenten elektrisch von einem Dach des Schienenfahrzeugs und von sekundären Stromkreisen trennen.

Die Druckschrift EP 2 567 855 A2 beschreibt eine Anordnung, bei der ein Stromabnehmer, der sich unterhalb eines Fahrdrahtes befindet und Teil eines kapazitiven Spannungsteilers ist, zur Ermittlung des Spannungssystems am Fahrdraht dient. Der Spannungsteiler wird insgesamt zwischen den Komponenten Fahrdraht, Stromabnehmer und Dach eines Schienenfahrzeugs gebildet. Außerdem kann ein Spannungssystem eines Nebenfahrdrahtes fälschlicherweise als das benötigte Spannungssystem identifiziert werden.

Die Druckschrift US 4,121,154 betrifft einen Spannungsteiler mit einer angeschlossenen Elektronik, die dazu dienen, die Spannungshöhe in einer Hochspannungsleitung zu messen bzw. zu errechnen. Der Spannungsteiler benötigt eine spezielle Abschirmung, die den Bauaufwand erhöht. Auch die Unterbringung der Elektronik innerhalb der Abschirmung erhöht den Bau- bzw. Montageaufwand.

Die Druckschrift EP 0 222 278 A1 offenbart einen kapazitiven Sensor, mit dessen Hilfe eine Spannung oder eine Frequenz in einer Verteilerleitung oder einem Bus ermittelt werden kann. Eine Anordnung von mehreren derartigen Sensoren dient zur Spannungsmessung bzw. Phasenerkennung, wobei jeder Sensor einer eigenen Leitung zugeordnet ist. Nachteilig ist hierbei der komplizierte Aufbau der Sensoren.

Der Erfindung liegt daher die Aufgabe zu Grunde, eine Vorrichtung und ein Verfahren zur zuverlässigen Erkennung eines Spannungssystems in einem Fahrdraht für ein Schienenfahrzeug zu schaffen, wobei die Erkennung vor einem Anheben eines Stromabnehmers erfolgt, nur ein geringer Bauaufwand erforderlich ist und eine Verwechslung des Spannungssystems am Fahrdraht mit dem Spannungssystem eines Nebenfahrdrahtes vermieden wird.

Diese Aufgabe wird erfindungsgemäß mit einer Vorrichtung zum Erkennen eines Spannungssystems nach Anspruch 1 und ein Schienenfahrzeug nach Anspruch 11 gelöst. Weiterhin wird die Aufgabe mit einem Verfahren zum Erkennen eines Spannungssystems nach Anspruch 12 gelöst. Vorteilhafte Ausgestaltungen der Erfindung sind in den Unteransprüchen enthalten.

Erfindungsgemäß besteht die Lösung der Aufgabe in einer Vorrichtung zum Erkennen eines Spannungssystems, das an einem Fahrdrahtabschnitt für eine Schienenfahrzeuganlage anliegt, wobei die Schienenfahrzeuganlage außer dem Fahrdrahtabschnitt mindestens ein Schienenfahrzeug umfasst und die Vorrichtung mindestens eine Messanordnung zwischen einem Fahrdrahtabschnitt und einem Dachbereich des Schienenfahrzeugs aufweist, die mit mindestens einer Auswerteeinheit verbunden ist, und wobei die Messanordnung mindestens eine kapazitive Einheit aufweist. Die Vorrichtung umfasst mindestens zwei Messanordnungen, wobei mindestens zwei kapazitive Einheiten den Fahrdrahtabschnitt und jeweils ein Sensorelement umfassen und wobei mindestens zwei Strommesseinheiten jeweils ein Sensorelement mit dem Dachbereich des Schienenfahrzeugs verbinden.

Diese Gestaltung der Vorrichtung mit mindestens zwei Messanordnungen bzw. mindestens zwei kapazitiven Einheiten und mindestens zwei zugehörigen Sensorelementen mit daran angeschlossenen Strommesseinheiten ermöglicht eine kontaktlose Erkennung des Spannungssystems ohne eine galvanische Verbindung zwischen Stromabnehmer und zugehöriger Fahrleitung gemäß dem Stand der Technik. Mindestens zwei Sensorelemente sind jeweils Teil einer kapazitiven Einheit, so dass an jedem Sensorelement eine eigene Messung durchgeführt werden kann. Im Gegensatz zum Stand der Technik ist die Vorrichtung unabhängig vom Stromabnehmer.

In einer besonderen Ausgestaltung der Erfindung ist das Sensorelement mit mindestens einer Isolierhalterung am Dachbereich des Schienenfahrzeugs befestigt und gegenüber dem Dachbereich isoliert. Bei der Isolierhalterung werden zwei Funktionen in ein Bauteil integriert, nämlich die Isolierung und die Befestigung des Sensorelements.

Insbesondere können die Sensorelemente in einer Querrichtung des Schienenfahrzeugs nebeneinander angeordnet sein und Abstände zu einander aufweisen, die vorzugsweise gleich groß sind.

Die Anordnung der Sensorelemente nebeneinander bewirkt, dass Messungen in einer Querrichtung des Fahrdrahtabschnitts erfolgen können. Die gleich großen Abstände bewirken eine gute Vergleichbarkeit der Messergebnisse.

Außerdem kann eine gemeinsame Mittellinie der Sensorelemente entlang der Querrichtung des Schienenfahrzeugs verlaufen. Alternativ oder zusätzlich können die Sensorelemente in einer Längsrichtung des Schienenfahrzeugs in demselben Abschnitt angeordnet sein. Durch eine gemeinsame Mittellinie entsteht eine symmetrische Anordnung, die ebenfalls eine gute Vergleichbarkeit der Messergebnisse ermöglicht. Wenn die Sensorelemente im selben Längsabschnitt angeordnet sind, wird eine kompakte Bauweise erreicht. Außerdem werden die Messungen dann im selben Fahrdrahtabschnitt durchgeführt.

Vorzugsweise können die Sensorelemente in einer senkrechten Richtung des Schienenfahrzeugs in demselben Abschnitt angeordnet sein. Hierdurch werden ebenfalls eine gute Vergleichbarkeit der Messwerte und eine kompakte Bauweise erzielt.

Weiterhin können die Sensorelemente unterschiedliche geometrische Formen oder gleichartige geometrische Formen aufweisen. Gleichartige geometrische Formen verringern den Herstellungsaufwand. Andererseits ermöglichen unterschiedliche geometrische Formen eine spezielle Anpassung der Sensorelemente an die Bauraumverhältnisse in dem Dachabschnitt.

Zusätzlich können die Sensorelemente unterschiedliche Abmessungen oder im Wesentlichen gleiche Abmessungen aufweisen, wobei insbesondere eine Fläche b x l jedes Sensorelements 300 cm2 betragen kann. Die Sensorelemente können durch unterschiedliche Abmessungen an die Bauraumverhältnisse im Dachbereich angepasst werden. Andererseits ermöglichen gleiche Abmessungen eine kostengünstige Herstellung.

In einer speziellen Ausgestaltung der Erfindung beträgt der Abstand der Sensorelemente zum Dachbereich des Schienenfahrzeugs zwischen 50 mm und 550 mm. Bei einem Abstand von 550 mm ist die Messempfindlichkeit der Sensorelemente am höchsten. Bei einem Abstand von 50 mm zum Dachbereich ist die Bauweise am kompaktesten und die Vergleichbarkeit der Messergebnisse der zwei Sensorelemente am höchsten. Insgesamt sind die Messergebnisse in diesem Abstandsbereich besonders zuverlässig. Der Fahrdraht kann dabei zwischen 1 m und 3 m über dem Dachbereich liegen.

Außerdem kann ein Schienenfahrzeug mindestens zwei Sensorelemente für die Vorrichtung umfassen.

Weiterhin besteht die Lösung der Aufgabe in einem Verfahren zum Erkennen eines Spannungssystems, das an einem Fahrdrahtabschnitt einer Schienenfahrzeuganlage anliegt, mittels der Vorrichtung, wobei mit Hilfe der Messanordnung mindestens eine elektrische Eigenschaft des Fahrdrahtes ermittelt wird, wobei mittels der mindestens zwei Strommesseinheiten an jedem Sensorelement mindestens einmal eine Messung durchgeführt wird und die Auswerteeinheit aus mindestens zwei Messergebnissen der Strommesseinheiten die elektrische Eigenschaft des Fahrdrahtes berechnet.

Das Messen des Stroms zwischen den Sensoreinheiten und dem Dachbereich und die Berechnung der elektrischen Eigenschaft aus dem gemessenen Strom, ermöglichen ein zuverlässiges Erkennen des Spannungssystems. Im Gegensatz zum Stand der Technik werden die berechneten Werte relativ zu einander bewertet. Es können Berechnungen zu derselben elektrischen Eigenschaft durchgeführt werden. Es können jedoch auch Berechnungen zu mindestens zwei verschiedenen elektrischen Eigenschaften, z.B. einer Spannung oder einer Frequenz, durchgeführt werden.

Die Sensorelemente können an oder in einem gemeinsamen Bauteil angebracht sein, das auf dem Dachbereich angeordnet ist. Dadurch wird der Aufwand für Montagearbeiten am Dachbereich verringert.

Die Sensorelemente können jeweils einen teilsensitiven Bereich auf einem gemeinsamen Bauteil ausbilden. Dadurch verringert sich der Bauaufwand.

Außerdem werden an den Sensorelementen gemessene Strommesswerte in einem binären System in Werte von Null oder Eins übersetzt. Die binären Werte ermöglichen eine Unterscheidung zwischen einem Wert von Eins für ein Wechselspannungssystem und einem Wert von Null für ein Gleichspannungssystem bzw. keine Spannung.

Weiterhin kann die Auswerteeinheit in der Querrichtung des Schienenfahrzeugs ein charakteristisches Muster der binären Werte erkennen und anhand des charakteristischen Musters den Fahrdrahtabschnitt vom Nebenfahrdrahtabschnitt unterscheiden. Die Kombination und Reihenfolge der binären Werte in Querrichtung des Schienenfahrzeugs ergibt ein charakteristisches Muster, aus dem sich eine Unterscheidung des Fahrdrahtabschnitts von Nebenfahrdrahtabschnitt ableiten lässt.

In einer vorteilhaften Weiterbildung der Erfindung kann vor dem Erkennen des Spannungssystems mittels der Vorrichtung
- der Fahrzeugführer das vermutlich vorhandene Spannungssystem auswählen,
- und nach dem Erkennen des Spannungssystems mittels der Vorrichtung (1)
- eine Meldung erfolgen, ob das erkannte Spannungssystem mit dem vom Fahrzeugführer ausgewählten Spannungssystem übereinstimmt,
- bei einer Übereinstimmung ein zum Spannungssystem gehöriger Stromabnehmer ausgewählt und angehoben werden,
- eine betriebliche Spannungsmessung am Stromabnehmer den von der Vorrichtung (1) ermittelten Spannungswert verifizieren und
- bei erfolgreicher Verifizierung ein Hauptschalter geschlossen werden.

Hierbei ist es vorteilhaft, dass die Erkennung des Spannungssystems bereits vor dem Anheben des Stromabnehmers erfolgt und damit der Stromabnehmer besser vor Spannungssystemen geschützt ist, die nicht zu dem Stromabnehmer passen.

Im Folgenden wird ein Ausführungsbeispiel der Erfindung anhand von fünf Figuren näher erläutert. Es zeigen:
Fig. 1 eine detaillierte schematische Vorderansicht einer erfindungsgemäßen Vorrichtung,
Fig. 2 eine schematische Vorderansicht von drei Sensorelementen,
Fig. 3 eine schematische Draufsicht auf drei Sensorelemente,
Fig. 4 eine schematische Seitenansicht von drei Sensorelementen und
Fig. 5 eine vereinfachte schematische Vorderansicht der Vorrichtung in Verbindung mit Nebenfahrdrahtabschnitten.

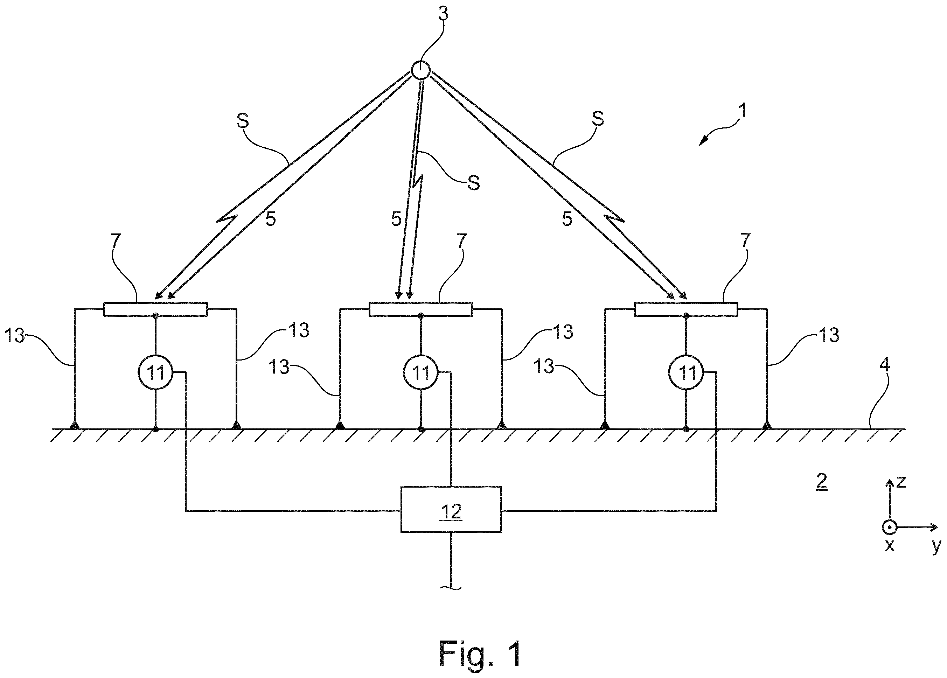

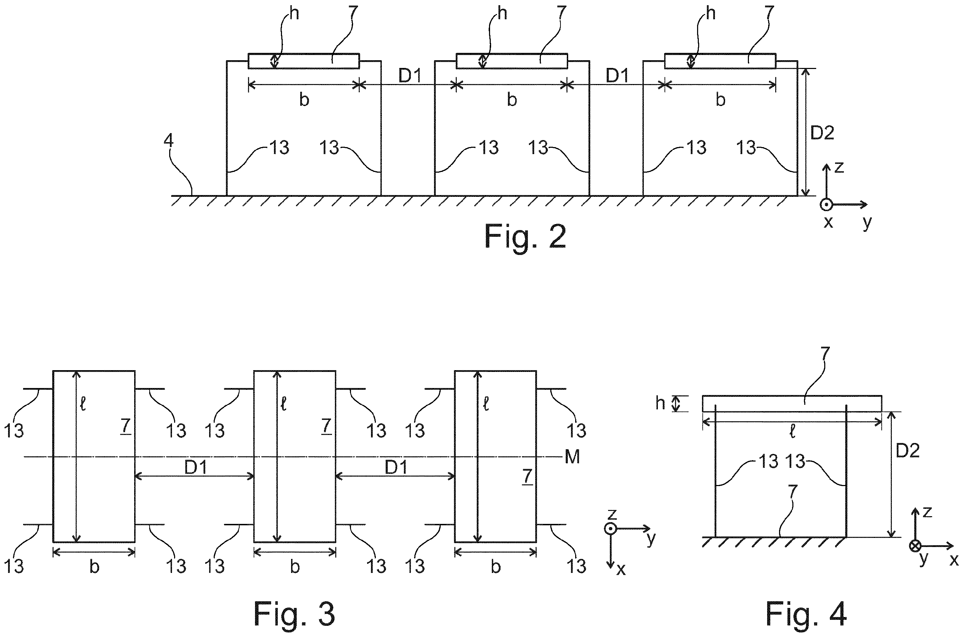

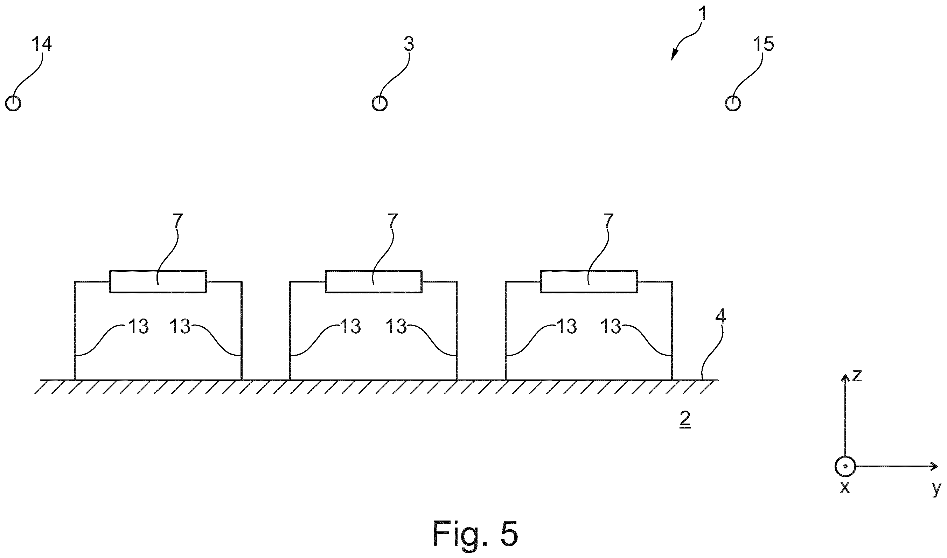

Die Fig. 1 und 5 zeigen eine erfindungsgemäße Vorrichtung 1 auf einem Dachbereich 4 eines in den Figuren lediglich angedeuteten Schienenfahrzeugs 2 in einer ansonsten nicht weiter dargestellten Schienenfahrzeuganlage. In Figur 5 sind außer einem Fahrdrahtabschnitt 3 der Schienenfahrzeuganlage auch ein erster Nebenfahrdrahtabschnitt 14 und ein zweiter Nebenfahrdrahtabschnitt 15 dargestellt. Die Fig. 2 bis 4 zeigen geometrische Abmessungen von Sensorelementen 7 der Vorrichtung 1.

In Fig. 1 ist die Vorrichtung 1 mit drei Messanordnungen zwischen dem Fahrdrahtabschnitt 3 und dem Dachbereich 4 des Schienenfahrzeugs dargestellt. Es können jedoch auch mehr als drei Messanordnungen vorhanden sein. Jede Messanordnung weist eine kapazitive Einheit 5 auf, die den Fahrdrahtabschnitt 3 und jeweils ein Sensorelement 7 umfasst. Außerdem umfasst jede Messanordnung eine Strommesseinheit 11, die elektrisch und mechanisch an das zugehörige Sensorelement 7 und den Dachbereich 4 angeschlossen ist. Eine Auswerteeinheit 12 ist elektrisch und mechanisch mit allen Strommesseinheiten 11 verbunden.

Jedes Sensorelement 7 ist aus einem elektrisch leitfähigen oder einem halbleitenden Material, z.B. Leitlack auf einem Trägermaterial, gebildet und an mindestens einer Isolierhalterung 13 befestigt. Die Isolierhalterungen 13 sind auch am Dachbereich 4 befestigt. Jede Isolierhalterung 13 muss das zugehörige Sensorelement 7 gegenüber dem Dachbereich 4 sicher und zuverlässig elektrisch isolieren, auch unter Umwelteinflüssen, wie z.B. Betauung, Regen, Schmutz oder Schnee.

In den Fig. 2 bis 4 sind die geometrischen Eigenschaften der drei Sensorelemente 7 dargestellt. Jedes Sensorelement 7 ist rechteckig und weist in einer Querrichtung y des Schienenfahrzeugs eine Breite b auf. In einer senkrechten Richtung z des Schienenfahrzeugs weisen die Sensorelemente 7 jeweils eine Höhe h auf. In einer Längsrichtung bzw. Fahrtrichtung x des Schienenfahrzeugs weisen die Sensorelemente jeweils eine Länge l auf. Die optimale Flächengröße jedes Sensorelements 7 beträgt 300 cm2 für eine Fläche, die durch die Maße b x l definiert ist. Die Länge l kann daher z.B. 30 cm und die Breite b entsprechend 10 cm betragen. In Fig. 3 besitzen die drei Sensorelemente eine gemeinsame Mittellinie M in der Querrichtung y.

Für die Form und Größe der Sensorelemente 7 ist jedoch auch jede beliebige Variante möglich. Schmale Formen weisen einen geringen Platzbedarf auf, während Breite Formen eine gute elektrische Sensitivität und mechanische Stabilität aufweisen. Gleichartige Formen und Größen ermöglichen eine gute Standardisierung der Bauteile. Es ist jedoch auch möglich, für verschiedene Sensorelemente 7 verschiedene Formen und Größen zu wählen. Dies ermöglicht eine gute Integration der Sensorelemente 7 in den Dachbereich 4. Auch eine Integration von Sensorelementen 7 in Containerdeckel ist möglich. Dadurch können Flächen für Sensorelemente 7 beansprucht werden, die größer sind als 300 cm2.

In der Querrichtung y sind die Sensorelemente 7 mit einem Abstand D1 voneinander beabstandet. Jeder Abstand D1 kann zwischen 200 mm und 1200 mm betragen, einschließlich eines Toleranzbereiches für die Endwerte 200 mm und 1200 mm. In der senkrechten Richtung z sind die Sensorelemente jeweils im gleichen senkrechten Abstand D2 vom Dachbereich 4 des Schienenfahrzeugs beabstandet. Jeder Abstand D2 kann zwischen 50 mm und 550 mm betragen, einschließlich eines Toleranzbereichs für die Endwerte 50 mm und 550 mm.

Jedes Sensorelement 7 ist mit vier Isolierhalterungen 13 am Dachbereich 4 des Schienenfahrzeugs befestigt. Die Isolierhalterungen 13 sind senkrecht ausgebildet und auf der Höhe der Sensorelemente 7 waagerecht abgewinkelt. Die Anzahl der Isolierhalterungen 13 kann jedoch beliebig gewählt werden. Auch die Form der Isolierhalterungen 13 kann beliebig gewählt werden. Es können z.B. Sensorelemente 7 untereinander mit waagerechten Isolierhalterungen verbunden sein, wobei z.B. nur die außenstehenden Sensorelemente 7 mit Isolierhalterungen 13 an dem Dachbereich 4 befestigt sind. Dadurch kann die Anzahl der am Dachbereich 4 befestigten Isolierhalterungen 13 reduziert werden.

In Fig. 5 ist die Vorrichtung 1 vereinfacht dargestellt. Zusätzlich zum Fahrdrahtabschnitt 3 sind der Nebenfahrdrahtabschnitt 14 und der Nebenfahrdrahtabschnitt 15 dargestellt, die jeweils unterschiedlich weit von jedem Sensorelement 7 entfernt sind. Der Fahrdrahtabschnitt 3 und die beiden Nebenfahrdrahtabschnitte 14 und 15 sind Abschnitte von Hochspannungsleitungen bzw. Fahrdrähten in der Längsrichtung x. Die Nebenfahrdrahtabschnitte 14 und 15 sind Abschnitte von Fahrdrähten in benachbarten Gleisanlagen.

Im Betrieb liegt eine Hochspannung S an der kapazitiven Einheit 5 zwischen dem Fahrdrahtabschnitt 3 und dem zugehörigen Sensorelement 7 an. Wenn die Hochspannung S eine Wechselspannung ist, erzeugt diese im Sensorelement 7 einen Strom, der vom Sensorelement 7 über die jeweils zugehörige Strommesseinheit 11 zum Dachbereich 4 geleitet wird. Dieser Strom wird von den Strommesseinheiten 11 gemessen. Es werden Ströme von weniger als 10 µA gemessen. Die Strommesseinheiten 11 leiten Messergebnisse an die Auswerteeinheit 12 weiter. Aus den Messergebnissen können die elektrischen Eigenschaften des Fahrdrahtabschnitts 3 berechnet werden, d.h. eine Spannung und eine Frequenz. Die Auswerteeinrichtung 12 kann verschiedene Arten von Auswertungen vornehmen. Aus mehreren Messergebnissen in verschiedenen Sensorelementen 7 kann für die gleiche elektrische Eigenschaft z.B. ein Mittelwert in der Auswerteeinheit 11 berechnet werden. Es können z.B. auch Mittelwerte aus Wiederholungsmessungen berechnet werden.

Mit Hilfe der Auswerteeinheit kann z.B. eine Wechselspannung von 15 kV oder 25 kV gemäß in Europa vorhandenen Spannungssystemen berechnet werden. Eine Nullspannung ist ein Hinweis auf ein Gleichspannungssystem oder einen energiefreien oder geerdeten Fahrdrahtabschnitt 3.

Mit Hilfe der Auswerteeinheit kann z.B. eine Frequenz von 16,7 Hz für eine Wechselspannung von 15 kV oder eine Frequenz von 50 Hz für eine Wechselspannung von 25 kV berechnet werden. Eine Nullfrequenz ist ein Hinweis auf ein Gleichspannungssystem oder einen energiefreien oder geerdeten Fahrdrahtabschnitt 3. Der Toleranzbereich für die Frequenzmessung liegt bei ± 1 Hz.

In einer Anordnung mit einem Fahrdrahtabschnitt 3 und mindestens einem Nebenfahrdrahtabschnitt 14 bzw. 15 innerhalb der Schienenfahrzeuganlage kann der Fahrdrahtabschnitt 3 erkannt werden. Die Erkennung erfolgt anhand der Messergebnisse der Strommesseinheiten 11, die in einem binären System ausgewertet werden. Dabei erzeugt jeweils ein Sensorelement 7, das am nächsten am Fahrdrahtabschnitt 3 bzw. einem Nebenfahrdrahtabschnitt 14, 15 angeordnet ist, zunächst einen zu dem nächstgelegenen Fahrdrahtabschnitt 3 bzw. Nebenfahrdrahtabschnitt 14, 15 gehörigen Strommesswert. Die drei Strommesswerte werden nach der Umrechnung in das binäre System nur relativ zu einander bewertet.

Jedes Sensorelement 7 liefert einen Strommesswert. Die Strommesswerte werden von der Auswerteeinheit 12 zueinander ins Verhältnis gesetzt. Die Größe und Reihenfolge der Strommesswerte in Querrichtung y des Schienenfahrzeugs ergibt ein Muster. Mit Hilfe eines Vergleichs mit bekannten Mustern werden die Strommesswerte in binären Werten abgebildet. Die Auswerteeinheit 12 bewertet dann mit Hilfe des binären Systems, ob ein Fahrdrahtabschnitt 3 und ein Nebenfahrdrahtabschnitt 14 bzw. 15 mit Wechselspannung beaufschlagt ist oder nicht. Ein binärer Wert von Eins kennzeichnet einen Wechselspannung führenden Fahrdrahtabschnitt 3 oder Nebenfahrdrahtabschnitt 14 bzw. 15. Ein binärer Wert von Null kennzeichnet einen energiefreien, geerdeten oder Gleichspannung führenden Fahrdrahtabschnitt 3 oder Nebenfahrdrahtabschnitt 14 bzw. 15. Anhand des daraus entstehenden charakteristischen binären Musters kann die Auswerteeinheit 12, insbesondere bei einer Wechselspannung, eine Unterscheidung des Fahrdrahtabschnitts 3 von den beiden Nebenfahrdrahtabschnitten 14 bzw. 15 ableiten.

Für Fig. 5 mit einem ersten Nebenfahrdrahtabschnitt 14 und einem zweiten Nebenfahrdrahtabschnitt 15 sind die charakteristischen binären Muster in der Querrichtung y in der folgenden Tabelle 1 dargestellt.

**Tabelle 1: Charakteristische binäre Muster in der Querrichtung y**

| Muster | Erster Nebenfahrdrahtabschnitt 14 | Fahrdrahtabschnitt 3 | Zweiter Nebenfahrdrahtabschnitt 15 | Erkanntes Spannungssystem am Fahrdraht 3 |
|---|---|---|---|---|
| A | 0 | 1 | 0 | Wechselspannungssystem |
| B | 0 | 1 | 1 | Wechselspannungssystem |
| C | 1 | 1 | 0 | Wechselspannungssystem |
| D | 1 | 1 | 1 | Wechselspannungssystem |
| E | 1 | 0 | 1 | Gleichspannungssystem oder keine Spannung |
| F | 1 | 0 | 0 | Gleichspannungssystem oder keine Spannung |
| G | 0 | 0 | 1 | Gleichspannungssystem oder keine Spannung |
| H | 0 | 0 | 0 | Gleichspannungssystem oder keine Spannung |

Bei den Mustern A, B, C, und D wird eindeutig ein Wechselspannungssystem am Fahrdrahtabschnitt 3 erkannt. Die binären Werte der Nebenfahrdrahtabschnitte 14, 15 können die Bestimmung des Spannungssystems am Fahrdraht 3 nicht verfälschen.

Bei den Mustern E, F und G könnte ohne die Vorrichtung 1 ein binärer Wert von Eins an einem Nebenfahrdrahtabschnitt 14 oder 15 fälschlicherweise als ein Hinweis auf ein Wechselspannungssystem im Fahrdrahtabschnitt 3 gedeutet werden, denn der Wert von Eins würde den Wert von Null überlagern. Mit Hilfe der Vorrichtung 1 kann jedoch zwischen verschiedenen Messwerten an den drei Sensorelementen 7 unterschieden werden. Wenn ein Wert von Eins an mindestens einem Nebenfahrdrahtabschnitt 14, 15 anliegt und am Fahrdrahtabschnitt 3 ein Wert von Null ermittelt wird, erkennt die Auswerteeinheit 12 zuverlässig ein Gleichspannungssystem bzw. einen energiefreien oder geerdeten Fahrdrahtabschnitt 3.

Bei Muster H ist das Ergebnis eindeutig. Sowohl der Fahrdrahtabschnitt 3 als auch die Nebenfahrdrahtabschnitte 14, 15 erzeugen binäre Werte von Null. Damit ist klar erkennbar, dass ein Gleichspannungssystem oder keine Spannung anliegt.

Die Erkennung des Spannungssystems des Fahrdrahtabschnitts 3 ist auch dann möglich, wenn jeder Fahrdrahtabschnitt 3 bzw. Nebenfahrdrahtabschnitt 14 und 15 den gleichen Abstand zum nächstgelegenen Sensorelement 7 aufweist.

Mit Hilfe der verschiedenen Auswertungen kann also ein Spannungssystem in einer Schienenfahrzeuganlage sicher erkannt werden. Zusätzlich kann ein Fahrdrahtabschnitt 3 von einem Nebenfahrdrahtabschnitt 14 bzw. 15 unterschieden werden. Daher können ein Stromabnehmer und direkt mit diesem verbundene Komponenten für ein Gleichspannungssystem mit 750 V, 1500 V oder 3000 V mit kleineren Isolatoren auskommen als ein Stromabnehmer und direkt mit diesem verbundene Komponenten für ein Wechselspannungssystem mit 15 kV / 16,7 Hz oder 25 kV / 50 Hz. Dadurch kann eine bedeutsame Gewichts- und Bauraumeinsparung erzielt werden.

Bevor das Spannungssystem erkannt wird, wählt der Fahrzeugführer das vermutlich vorhandene Spannungssystem aus. Nachdem das Spannungssystem von der Vorrichtung 1 erkannt worden ist, wird geprüft, ob das erkannte Spannungssystem mit dem ausgewählten Spannungssystem übereinstimmt. Bei positivem Ergebnis wird ein zugehöriger Stromabnehmer automatisch oder manuell ausgewählt und angehoben.

Wenn für den Fahrdrahtabschnitt 3 ein Wert von Eins erkannt wird, darf nur ein Stromabnehmer für Wechselspannungssysteme ausgewählt und angehoben werden. Wenn fälschlicherweise ein Gleichspannungssystem vom Fahrzeugführer gewählt wurde, darf kein Stromabnehmer für Gleichspannungssysteme angehoben werden.

Wenn nur für mindestens einen Nebenfahrdrahtabschnitt 14, 15 ein binärer Wert von Eins ermittelt wird, liegt nur an dem Nebenfahrdrahtabschnitt 14, 15 eine Wechselspannung an. In diesem Fall darf ein Stromabnehmer für Gleichspannungssysteme ausgewählt und angehoben werden, aber kein Stromabnehmer für Wechselspannungssysteme. Eventuell ist im Fahrdrahtabschnitt 3 aber auch gar kein Spannungssystem vorhanden. Dann kann der Stromabnehmer wieder gesenkt werden.

Eine betriebliche Spannungsmessung am Stromabnehmer verifiziert den von der Vorrichtung 1 ermittelten Spannungswert. Bei positivem Ergebnis wird ein Hauptschalter geschlossen, und weitere Funktionseinheiten zum Starten des Schienenfahrzeugs werden zugeschaltet.

Die Systemerkennung mittels der Vorrichtung 1 erfolgt somit zentral. Die betriebliche Spannungsmessung erfolgt lokal an dem angehobenen Stromabnehmer. Pro Stromabnehmer ist also eine betriebliche Spannungsmessung möglich.

Fahrzeuge, bei denen eine Stromabnehmerauswahl nach dem Stand der Technik durchgeführt wird, können mit der Vorrichtung 1 nachgerüstet werden. Wenn die Vorrichtung 1 in Fahrtrichtung vor den Stromabnehmern angeordnet ist, erfolgt die Systemerkennung mittels der Vorrichtung 1, bevor ein Stromabnehmer eine Übergangsstelle zwischen zwei Spannungssystemen erreicht. Dadurch ist es möglich, einen falsch ausgewählten und angehobenen Stromabnehmer noch rechtzeitig wieder zu senken und Schäden zu vermeiden. Zum Absenken eines falsch ausgewählten Stromabnehmers kann eine herkömmliche Schnellsenkeinrichtung (engl.: Automatic Dropping Device/ADD) verwendet werden.

### Bezugszeichenliste

- 1: Vorrichtung
- 2: Schienenfahrzeug
- 3: Fahrdrahtabschnitt
- 4: Dachbereich
- 5: Kapazitive Einheit
- 7: Sensorelement
- 11: Strommesseinheit
- 12: Auswerteeinheit
- 13: Isolierhalterung
- 14: Erster Nebenfahrdrahtabschnitt
- 15: Zweiter Nebenfahrdrahtabschnitt

- S: Hochspannung
- l: Länge
- b: Breite
- h: Höhe
- D1: Abstand
- D2: Abstand
- M: Mittellinie
- x: Längsrichtung
- y: Querrichtung
- z: Senkrechte Richtung

## Patentansprüche

1. Vorrichtung (1) zum Erkennen eines Spannungssystems, das an einem Fahrdrahtabschnitt (3) für eine Schienenfahrzeuganlage anliegt, wobei die Schienenfahrzeuganlage außer dem Fahrdrahtabschnitt (3) mindestens ein Schienenfahrzeug (2) umfasst und die Vorrichtung (1) mindestens eine Messanordnung zwischen einem Fahrdrahtabschnitt (3) und einem Dachbereich (4) des Schienenfahrzeugs (2) aufweist, die mit mindestens einer Auswerteeinheit (12) verbunden ist, und wobei die Messanordnung mindestens eine kapazitive Einheit (5) aufweist, **dadurch gekennzeichnet, dass** die Vorrichtung mindestens zwei Messanordnungen umfasst, wobei mindestens zwei kapazitive Einheiten (5) den Fahrdrahtabschnitt (3) und jeweils ein Sensorelement (7) umfassen und wobei mindestens zwei Strommesseinheiten (11) jeweils ein Sensorelement mit dem Dachbereich (4) des Schienenfahrzeugs (2) verbinden.

2. Vorrichtung (1) nach Anspruch 1, **dadurch gekennzeichnet, dass** das Sensorelement (7) mit mindestens einer Isolierhalterung (13) am Dachbereich (4) des Schienenfahrzeugs (2) befestigt und gegenüber dem Dachbereich (4) isoliert ist.

3. Vorrichtung (1) nach Anspruch 1 oder 2, **dadurch gekennzeichnet, dass** die Sensorelemente (7) in einer Querrichtung (y) des Schienenfahrzeugs (2) nebeneinander angeordnet sind und Abstände (D1) zu einander aufweisen, die vorzugsweise gleich groß sind.

4. Vorrichtung (1) nach einem der Ansprüche 1 bis 3, **dadurch gekennzeichnet, dass** eine gemeinsame Mittellinie (M) der Sensorelemente (7) entlang der Querrichtung (y) des Schienenfahrzeugs (2) verläuft und/oder die Sensorelemente (7) in einer Längsrichtung (x) des Schienenfahrzeugs (2) in demselben Abschnitt angeordnet sind.

5. Vorrichtung (1) nach einem der vorhergehenden Ansprüche, **dadurch gekennzeichnet, dass** die Sensorelemente (7) in einer senkrechten Richtung (z) des Schienenfahrzeugs (2) in demselben Abschnitt angeordnet sind.

6. Vorrichtung (1) nach einem der vorhergehenden Ansprüche, **dadurch gekennzeichnet, dass** die Sensorelemente (7) unterschiedliche geometrische Formen oder gleichartige geometrische Formen aufweisen.

7. Vorrichtung (1) nach einem der vorhergehenden Ansprüche, **dadurch gekennzeichnet, dass** die Sensorelemente (7) unterschiedliche Abmessungen oder im Wesentlichen gleiche Abmessungen aufweisen, wobei insbesondere eine Fläche jedes Sensorelements (7) 300 cm² beträgt, wobei die Fläche durch die Maße b x l definiert ist, wobei b eine Breite des Sensorelements (7) und l eine Länge des Sensorelements (7) ist.

8. Vorrichtung (1) nach einem der vorhergehenden Ansprüche, **dadurch gekennzeichnet, dass** der Abstand (D2) der Sensorelemente (7) zum Dachbereich (4) des Schienenfahrzeugs zwischen 50 mm und 550 mm beträgt.

9. Vorrichtung nach einem der vorhergehenden Ansprüche, **dadurch gekennzeichnet, dass** die Sensorelemente (7) an oder in einem gemeinsamen Bauteil angebracht sind, das auf dem Dachbereich (4) angeordnet ist.

10. Vorrichtung nach einem der vorhergehenden Ansprüche, **dadurch gekennzeichnet, dass** die Sensorelemente (7) jeweils einen teilsensitiven Bereich auf einem gemeinsamen Bauteil ausbilden.

11. Schienenfahrzeug (2) mit einer Vorrichtung (1) gemäß den vorhergehenden Ansprüchen mit mindestens zwei Sensorelementen (7).

12. Verfahren zum Erkennen eines Spannungssystems, das an einem Fahrdrahtabschnitt (3) einer Schienenfahrzeuganlage anliegt, mittels einer Vorrichtung (1) nach einem der Ansprüche 1 bis 10, **dadurch gekennzeichnet, dass** mit Hilfe der Messanordnung mindestens eine elektrische Eigenschaft des Fahrdrahtabschnitts (3) ermittelt wird, wobei mittels der mindestens zwei Strommesseinheiten (11) an jedem Sensorelement (7) mindestens einmal eine Messung durchgeführt wird und die Auswerteeinheit aus mindestens zwei Messergebnissen der Strommesseinheiten (11) die elektrische Eigenschaft des Fahrdrahtabschnitts 3 berechnet.

13. Verfahren nach Anspruch 12, **dadurch gekennzeichnet, dass** an den Sensorelementen (7) gemessene Strommesswerte in einem binären System in Werte von Null oder Eins übersetzt werden.

14. Verfahren nach Anspruch 13, **dadurch gekennzeichnet, dass** die Auswerteeinheit (12) in der Querrichtung (y) des Schienenfahrzeugs ein charakteristisches Muster der binären Werte erkennt und anhand des charakteristischen Musters den Fahrdrahtabschnitt (3) vom Nebenfahrdrahtabschnitt (14, 15) unterscheidet.

15. Verfahren nach einem der Ansprüche 12 bis 14, **dadurch gekennzeichnet, dass** vor dem Erkennen des Spannungssystems mittels der Vorrichtung (1)
- der Fahrzeugführer das vermutlich vorhandene Spannungssystem auswählt,
- und dass nach dem Erkennen des Spannungssystems mittels der Vorrichtung (1)
- eine Meldung erfolgt, ob das erkannte Spannungssystem mit dem vom Fahrzeugführer ausgewählten Spannungssystem übereinstimmt,
- bei einer Übereinstimmung ein zum Spannungssystem gehörige Stromabnehmer ausgewählt und angehoben wird,
- eine betriebliche Spannungsmessung am Stromabnehmer den von der Vorrichtung (1) ermittelten Spannungswert verifiziert und
- bei erfolgreicher Verifizierung ein Hauptschalter geschlossen wird.

## Claims

1. Device (1) for detecting a voltage system which is applied to an overhead wire section (3) for a rail vehicle installation, the rail vehicle installation comprising, in addition to the overhead wire section (3), at least one rail vehicle (2) and the device (1), wherein the device (1) comprises at least one measuring arrangement located between the overhead wire section (3) and a roof area (4) of the rail vehicle (2), wherein the measuring arrangement is connected to at least one evaluation unit (12), and wherein the measuring arrangement comprises at least one capacitor unit (5), **characterized in that** the device comprises at least two measuring arrangements, wherein the at least two capacitor units (5) comprise the overhead wire section (3) and one sensor element (7) each, and wherein at least two current measuring units (11) each connecting a sensor element to the roof area (4) of the rail vehicle (2).

2. The device (1) according to claim 1, **characterised in that** the sensor element (7) is fastened to the roof region (4) of the rail vehicle (2) by at least one insulating holder (13) and is insulated from the roof region (4).

3. The device (1) according to claim 1 or 2, **characterised in that** the sensor elements (7) are arranged next to one another in a cross direction (y) of the rail vehicle (2) and have distances (D1) from one another which are preferably the same size.

4. The device (1) according to one of claims 1 to 3, **characterized in that** a common center line (M) of the sensor elements (7) runs along the transverse direction (y) of the rail vehicle (2) and/or the sensor elements (7) in a longitudinal direction (x) of the rail vehicle (2) are arranged in the same section.

5. The device (1) according to one of the preceding claims, **characterized in that** the sensor elements (7) in a vertical direction (z) of the rail vehicle (2) are arranged in the same section.

6. The device (1) according to one of the preceding claims, **characterized in that** the sensor elements (7) have different geometric shapes or geometric shapes of the same type.

7. The device (1) according to one of the preceding claims, **characterized in that** the sensor elements (7) have different dimensions or substantially the same dimensions, in particular an area of each sensor element (7) being 300 cm2, said area being defined by the dimensions b x l, where b is a width of the sensor element (7) and I is a length of the sensor element (7).

8. The device (1) according to one of the preceding claims, **characterized in that** the distance (D2) of the sensor elements (7) to the roof area (4) of the rail vehicle is between 50 mm and 550 mm.

9. The device according to one of the preceding claims, **characterized in that** the sensor elements (7) are mounted on or in a common component, which is arranged on the roof area (4).

10. The device according to one of the preceding claims, **characterised in that** the sensor elements (7) each form a partially sensitive region on a common component.

11. A rail vehicle (2) comprising a device (1) according to the preceding claims and at least two sensor elements (7).

12. A method for detecting a voltage system which is applied to an overhead wire section (3) of a rail vehicle system by means of a device (1) according to one of claims 1 to 10, **characterized in that** at least one electrical property of the overhead wire section (3) is determined with the aid of the measuring arrangement, a measurement being carried out at least once by means of the at least two current measuring units (11) on each sensor element (7), and the evaluation unit calculating the electrical property of the overhead wire section (3) from at least two measurement results of the current measuring units (11).

13. The method according to claim 12, **characterised in that** measured current values measured at the sensor elements (7) are translated into values of zero or one in a binary system.

14. The method according to claim 13, **characterized in that** the evaluation unit (12) recognizes a characteristic pattern of the binary values in the transverse direction (y) of the rail vehicle and distinguishes the overhead wire section (3) from a further overhead wire section (14, 15) based on the characteristic pattern.

15. The method according to one of claims 12 to 14, **characterized in that** prior to the detection of the voltage system by means of the device (1)
- the driver selects the presumed voltage system, and
- that after the detection of the voltage system by means of the device (1) a message is displayed whether the detected voltage system matches the voltage system selected by the driver,
- in case of a match, a pantograph belonging to the voltage system is selected and raised,
- an operational voltage measurement at the pantograph verifies the voltage value determined by the device (1), and
- a main switch is closed if verification is successful.

## Revendications

1. Dispositif (1) destiné à reconnaître un système de tension placé contre un tronçon de fil caténaire (3) destiné à un système de véhicule ferroviaire, le système de véhicule ferroviaire comprenant, outre le tronçon de fil caténaire (3), au moins un véhicule ferroviaire (2) et le dispositif (1) présentant au moins un agencement de mesure entre un tronçon de fil caténaire (3) et une zone de toit (4) du véhicule ferroviaire (2), lequel agencement de mesure est relié à au moins un module d'analyse (12), et l'agencement de mesure présentant au moins un module capacitif (5), **caractérisé en ce que** le dispositif (1) comprend au moins deux agencements de mesure, au moins deux modules capacitifs (5) comprennent chacun le tronçon de fil caténaire (3) un détecteur (7), et au moins deux modules de mesure de courant relient chacun un détecteur à la zone de toit (4) du véhicule ferroviaire (2).

2. Dispositif (1) selon la revendication 1, **caractérisé en ce que** le détecteur (7) est fixé à la zone de toit (4) avec au moins une fixation isolante (13) et est isolé par rapport à la zone de toit (4).

3. Dispositif (1) selon la revendication 1 ou la revendication 2, **caractérisé en ce que** les détecteurs (7) sont disposés côte à côte dans un sens transversal (y) du véhicule ferroviaire (2) et présentent des distances (D1) l'un par rapport à l'autre de préférence identiques.

4. Dispositif (1) selon l'une quelconque des revendications 1 à 3, **caractérisé en ce qu'**une ligne médiane commune (M) des détecteurs (7) passe le long du sens transversal (y) du véhicule ferroviaire (2), et/ou les détecteurs (7) sont disposés dans un sens longitudinal (x) du véhicule ferroviaire (2) dans le même tronçon.

5. Dispositif (1) selon l'une quelconque des revendications précédentes, **caractérisé en ce que** les détecteurs (7) sont disposés dans un sens vertical (z) du véhicule ferroviaire (2) dans le même tronçon.

6. Dispositif (1) selon l'une quelconque des revendications précédentes, **caractérisé en ce que** les détecteurs (7) présentent des formes géométriques différentes ou des formes géométriques identiques.

7. Dispositif (1) selon l'une quelconque des revendications précédentes, **caractérisé en ce que** les détecteurs (7) ont des dimensions différentes ou des dimensions essentiellement identiques, chaque détecteur (7) ayant, en particulier, une surface de 300 cm², la surface étant définie par les cotes l x L, l étant une largeur du détecteur (7) et L une longueur du détecteur (7) .

8. Dispositif (1) selon l'une quelconque des revendications précédentes, **caractérisé en ce que** la distance (D2) des capteurs (7) par rapport à la zone de toit (4) du véhicule ferroviaire mesure entre 50 mm et 550 mm.

9. Dispositif selon l'une quelconque des revendications précédentes, **caractérisé en ce que** les détecteurs (7) sont placés contre ou dans un composant commun disposé sur la zone de toit (4).

10. Dispositif selon l'une quelconque des revendications précédentes, **caractérisé en ce que** les détecteurs (7) constituent chacun une zone partiellement sensible sur un composant commun.

11. Véhicule ferroviaire (2) équipé d'un dispositif (1) selon les revendications précédentes et d'au moins deux détecteurs (7).

12. Procédé pour reconnaître un système de tension placé contre un tronçon de fil caténaire (3) d'un système de véhicule ferroviaire au moyen d'un dispositif (1) selon l'une quelconque des revendications 1 à 10, **caractérisé en ce qu'**au moins une propriété électrique du tronçon de fil caténaire (3) est déterminée à l'aide du dispositif de mesure, une mesure étant effectuée au moins une fois au moyen des au moins deux modules de mesure du courant (11) et le module d'analyse calculant la propriété électrique du tronçon de fil caténaire (3) à partir d'au moins deux résultats de mesure des modules de mesure du courant (11).

13. Procédé selon la revendication 12, **caractérisé en ce que** les valeurs de courant mesurées sur les détecteurs (7) sont transcrites en valeurs de zéro ou de un dans un système binaire.

14. Procédé selon la revendication 13, **caractérisé en ce que** le module d'analyse (12) reconnaît un modèle caractéristique des valeurs binaires dans le sens transversal (y) du véhicule ferroviaire et fait la distinction entre le tronçon de fil caténaire (3) et le tronçon de fil caténaire adjacent (14, 15) à l'aide du modèle caractéristique.

15. Procédé selon l'une quelconque des revendications 12 à 14, **caractérisé en ce que**, avant la reconnaissance du système de tension au moyen du dispositif (1),
- le conducteur du véhicule sélectionne le système de tension probablement présent,
- et **en ce que**, après la reconnaissance du système de tension au moyen du dispositif (1)
- un message est émis indiquant si le système de tension reconnu coïncide avec le système de tension sélectionné par le conducteur du véhicule,
- s'il coïncide, un pantographe faisant partie du système de tension est sélectionné et soulevé,
- une mesure de tension de service sur le pantographe vérifie la valeur de tension déterminée par le dispositif (1) et
- si la vérification réussit, un commutateur principal est fermé.
